# EUROPEAN PATENT APPLICATION

(11) **EP 4 372 817 A2**
(43) Date of publication of application: **22.05.2024**
(21) Application number: 24153468.4
(22) Date of filing: 30.05.2018
(51) Int. Cl.: H01L 25/16

(54) **LED BULB INCLUDING LED PACKAGE SET**

(30) Priority: 31.05.2017 KR 20170067992
(62) Divisional of application: 18809817.2
(71) Applicant: Seoul Semiconductor Co., Ltd., Gyeonggi-do 15429 (KR)
(72) Inventor: LEE, Seong Jin, 15429 Ansan-si (KR); LEE, Jong Kook, 15429 Ansan-si (KR)
(74) Representative: Stolmár & Partner Patentanwälte PartG mbB

(57) **Abstract**

The present invention relates to an LED package set and an LED bulb including the same. According to one embodiment of the present invention, provided is an LED package set comprising: a substrate; a first LED package arranged on the substrate and including at least one first LED chip; a second LED package arranged on the substrate and including at least one second LED chip; and a resistor arranged on the substrate, connected with the first LED package in series, and connected with the second LED package in parallel. In addition, the second LED package is connected with the first LED package and the resistor in parallel. Moreover, the first LED package and the second LED package emit lights having different color temperatures from each other.

## Description

### [Technical Field]

Embodiments of the present invention relate to an LED package set and an LED bulb including the same.

### [Background Art]

Conventionally, incandescent lamps using filaments have been widely used as luminaires. In general, operation of a filament-based incandescent lamp is based on the principle that light is obtained by temperature radiation caused by heating a tungsten filament in a vacuum glass bulb to high temperature through application of electricity.

Such a typical incandescent lamp is not suitable for long-term use due to short lifespan of the filament and has extremely low energy efficiency since most of energy supplied thereto is released as heat and only a fraction of the energy is converted into light.

Recently, light emitting diodes (LEDs) having long lifespan and high energy efficiency are used in luminaires.

### [Disclosure]

### [Technical Problem]

Embodiments of the present invention provide an LED package set which has high economic efficiency due to long lifespan and low heat generation thereof, and an LED bulb including the same.

Embodiments of the present invention provide an LED package set which allows regulation of color temperature of light emitted therefrom, and an LED bulb including the same.

Embodiments of the present invention provide an LED package set which can evenly emit light in all directions by emitting light in different directions, and an LED bulb including the same.

### [Technical Solution]

In accordance with one embodiment of the present invention, there is provided an LED package set including: a substrate; a first LED package disposed on the substrate and including at least one first LED chip; a second LED package disposed on the substrate and including at least one second LED chip; and a resistor disposed on the substrate, the resistor being connected in series to the first LED package and connected in parallel to the second LED package. The second LED package is connected in parallel to the first LED package and the resistor. The first LED package and the second LED package emit light having different color temperatures.

In accordance with another embodiment of the present invention, there is provided an LED bulb including: a base formed with an external electrode pad receiving electricity from an external power supply; an LED package set; a holder coupled to the LED package set; and a light transmissive cover enclosing the LED package set and coupled at one end thereof to the base. The LED package set includes a substrate having a pair of electrode pads formed at one end thereof, a first LED package including at least one first LED chip, a second LED package including at least one second LED chip, and a resistor. The holder is formed with a connection portion receiving one end of the LED package set and electrically connected to the pair of electrode pads of the substrate. The first LED package, the second LED package, and the resistor are disposed on the substrate. The first LED package and the second LED package are connected in parallel to one another and emit light having different color temperatures. The resistor is connected in series to the first LED package and connected in parallel to the second LED package.

### [Advantageous Effects]

According to the present invention, an LED package set and an LED bulb including the same can have long lifespan and low heat generation by employing an LED package instead of a tungsten filament, thereby improving economic efficiency.

In addition, the LED package set and the LED bulb including the same can emit light having a suitable color temperature according to an environment using at least two LED packages emitting light having different color temperatures.

Further, the LED package set and the LED bulb including the same include a resistor connected in series to one LED package and connected in parallel to the other LED package. Thus, the LED package set and the LED bulb can emit light changed in color temperature with change in voltage and current supplied to the LED package set.

### [Description of Drawings]

FIG. 1 and FIG. 2 are exemplary views of an LED package set according to one embodiment of the present invention.
FIG. 3 is a circuit diagram of the LED package set according to the embodiment.
FIG. 4 and FIG. 5 are exemplary views of an LED bulb according to a first embodiment of the present invention.
FIG. 6 is an exemplary view of an LED bulb according to a second embodiment of the present invention.

### [Best Mode]

The above and other aspects, features, and advantages of the present invention will become apparent from the detailed description of the following embodiments in conjunction with the accompanying drawings. It should be understood that the present invention is not limited to the following embodiments and may be embodied in different ways, and that the embodiments are provided for complete disclosure and a thorough understanding of the present invention by those skilled in the art. It should be noted that like components will be denoted by like reference numerals throughout the specification and the accompanying drawings. In addition, it will be understood that, although the terms "first", "second", "one", "the other", "upper", "lower", "upper surface", "lower surface", and the like may be used herein to describe various elements, components, regions, layers and/or sections, these elements, components, regions, layers and/or sections should not be limited by these terms. These terms are only used to distinguish one element, component, region, layer or section from another element, component, region, layer or section.

Hereinafter, embodiments of the present invention will be described with reference to the accompanying drawings.

In accordance with one embodiment of the present invention, an LED package set includes: a substrate; a first LED package disposed on the substrate and including at least one first LED chip; a second LED package disposed on the substrate and including at least one second LED chip; and a resistor disposed on the substrate, the resistor being connected in series to the first LED package and connected in parallel to the second LED package. The second LED package is connected in parallel to the first LED package and the resistor. The first LED package and the second LED package emit light having different color temperatures.

The LED package set is driven in a constant current mode. Electricity applied to the LED package set is changed according to a dimming signal. According to the present invention, as voltage applied to the LED package set is changed according to the dimming signal, a current distribution ratio between the first LED package and the second LED package is changed. As a result, a color temperature of mixed light composed of light emitted from the first LED package and light emitted from the second LED package is changed.

The substrate includes a pair of electrode pads formed thereon. One end of the first LED package and one end of the second LED package are connected to one of the pair of electrode pads. One end of the resistor is connected to the other end of the first LED package. The other end of the second LED package and the other end of the resistor are connected to the other of the pair of electrode pads.

Light from the first LED package according to an embodiment has a higher color temperature than light from the second LED package. A difference in color temperature between the light from the first LED package and the light from the second LED package may be more than or equal to 500 K. In addition, a difference in color temperature between the light from the first LED package and the light from the second LED package may be less than or equal to 1,000 K.

Current is distributed to the first LED package and the second LED package depending on resistance offered by the first LED package and the resistor connected in series and resistance offered by the second LED package.

A color temperature of mixed light composed of the light from the first LED package and the light from the second LED package is changed depending on current flowing through the first LED package and current flowing through the second LED package.

The first LED package may include a first wavelength conversion portion covering the at least one first LED chip. The second LED package may include a second wavelength conversion portion covering the at least one second LED chip.

For example, the first LED chip and the second LED chip may emit light having different color temperatures. Here, the first wavelength conversion portion and the second wavelength conversion portion may include phosphors having the same color temperature, respectively.

Alternatively, the LED package set may be configured such that the first LED chip and the second LED chip are both covered by a single common wavelength conversion portion. Here, the first LED chip and the second LED chip may emit light having different color temperatures.

The first LED chip may have the same size as the second LED chip, or may have a different size from the second LED chip. With increasing size of the first LED chip and the second LED chip, the first LED chip and the second LED chip have higher luminous efficacy due to increase in light emitting area thereof.

In accordance with another embodiment of the present invention, an LED bulb includes: a base formed with an external electrode pad receiving electricity from an external power supply; an LED package set; a holder coupled to the LED package set; and a light transmissive cover enclosing the LED package set and coupled at one end thereof to the base. The LED package set includes a substrate having a pair of electrode pads formed at one end thereof, a first LED package including at least one first LED chip, a second LED package including at least one second LED chip, and a resistor. The holder is formed with a connection portion receiving one end of the LED package set and electrically connected to the pair of electrode pads of the substrate. The first LED package, the second LED package, and the resistor are disposed on the substrate. The first LED package and the second LED package are connected in parallel to one another and emit light having different color temperatures. The resistor is connected in series to the first LED package and connected in parallel to the second LED package. Here, the LED package set is driven in a constant current mode.

One end of the first LED package and one end of the second LED package are connected to one of the pair of electrode pads. One end of the resistor is connected to the other end of the first LED package. The other end of the second LED package and the other end of the resistor are connected to the other of the pair of electrode pads.

Light from the first LED package according to an embodiment has a higher color temperature than light from the second LED package. A difference in color temperature between the light from the first LED package and the light from the second LED package may be more than or equal to 500 K. In addition, a difference in color temperature between the light from the first LED package and the light from the second LED package may be less than or equal to 1,000 K.

Current is distributed to the first LED package and the second LED package depending on resistance offered by the first LED package and the resistor connected in series and resistance offered by the second LED package. Here, the resistor is a fixed resistor whose resistance does not change.

In the LED bulb according to the present invention, a ratio of resistance offered by the first LED package and the resistor to resistance offered by the second LED package is changed with change in electricity applied to the LED package set. Current applied to the LED package set is distributed to the first LED package 110 and the second LED package in inverse proportion to the ratio.

A color temperature of mixed light composed of the light from the first LED package and the light from the second LED package is changed depending on current flowing through the first LED package and current flowing through the second LED package.

The connection portion of the holder is provided in the form of a groove or hole into which one end of the substrate is inserted. In addition, the connection portion includes a pair of connection terminals electrically connected to the pair of electrode pads of the substrate.

The substrate may further include a bent portion formed between the pair of electrode pads and the first LED chip, the second LED chip, or the resistor to allow the substrate to be bent upwards or downwards with respect thereto.

The first LED package may include a first wavelength conversion portion covering the at least one first LED chip. In addition, the second LED package may include a second wavelength conversion portion covering the at least one second LED chip.

For example, the first LED chip and the second LED chip may emit light having different color temperatures. Here, the first wavelength conversion portion and the second wavelength conversion portion may include phosphors having the same color temperature, respectively.

Alternatively, the LED package set may be configured such that the first LED chip and the second LED chip are both covered by a single common wavelength conversion portion. Here, the first LED chip and the second LED chip may emit light having different color temperatures.

The first LED chip may have the same size as the second LED chip, or may have a different size from the second LED chip. With increasing size of the first LED chip and the second LED chip, the first LED chip and the second LED chip have higher luminous efficacy due to increase in light emitting area thereof.

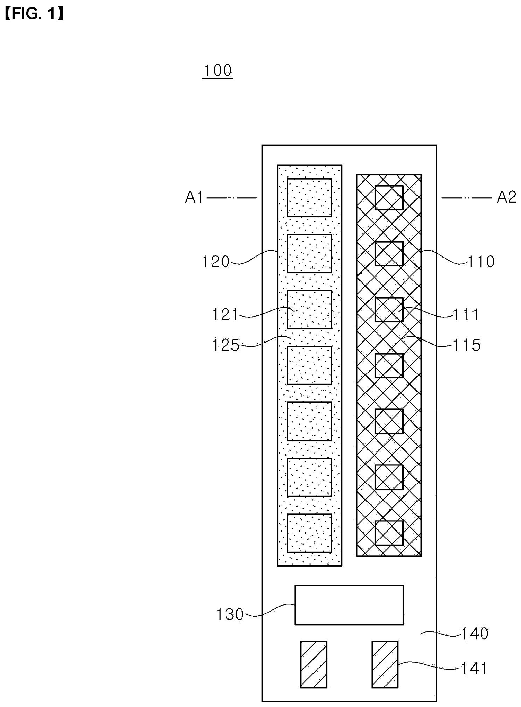

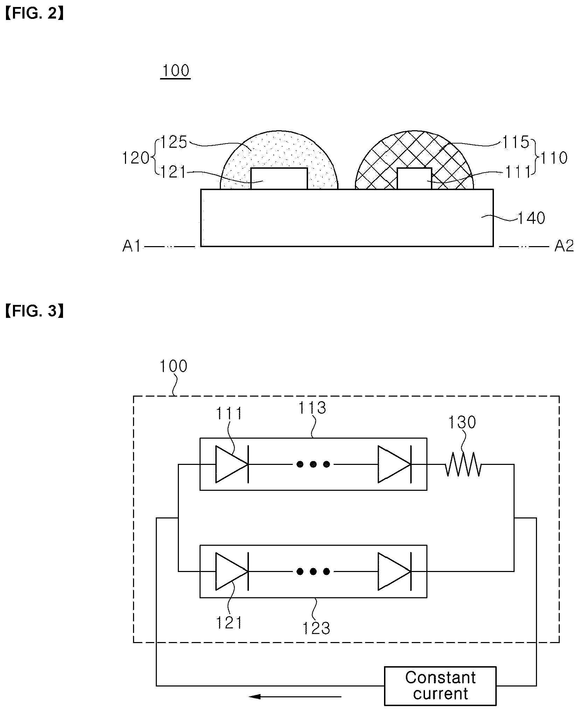

FIG. 1 and FIG. 2 are exemplary views of an LED package set according to one embodiment of the present invention.

Specifically, FIG. 1 is a plan view of an LED package set 100 according to one embodiment of the present invention. In addition, FIG. 2 is a sectional view of the LED package set 100 taken along line A1-A2 of FIG. 1.

Referring to FIG. 1 and FIG. 2, the LED package set 100 includes a substrate 140, a first LED package 110, a second LED package 120, and a resistor 130. The LED package set 100 is driven in a constant current mode.

The substrate 140 is a circuit substrate having a wiring circuit (not shown) formed thereon. For example, the substrate 140 may be any substrate suitable for forming a wiring circuit thereon, such as a printed circuit board, a metal substrate, and a glass substrate. In one embodiment, the substrate 140 may be a metal substrate. The metal substrate has high heat dissipation performance and thus can allow a plurality of LED chips or LED packages to be disposed thereon.

The substrate 140 includes a pair of electrode pads 141 formed at one end thereof. The pair of electrode pads 141 receives electricity for driving the first LED package 110 and the second LED package 120 from the outside of the LED package set 100. Here, electricity applied to the substrate 140 is changed according to a dimming signal.

The pair of electrode pads 141 formed on the substrate 140 is electrically connected to the first LED package 110, the second LED package 120, and the resistor 130.

The first LED package 110 is disposed on the substrate 140. The first LED package 110 includes a first LED chip 111 and a first wavelength conversion portion 115.

The first LED package 110 includes at least one first LED chip 111. In the first LED package 110 including plural first LED chips 111, the plural first LED chips 111 are electrically connected to one another to form an array.

The first wavelength conversion portion 115 is formed on the substrate 140 to cover the first LED chip 111. The first wavelength conversion portion 115 may be formed to collectively cover the plural first LED chips 111. Alternatively, the first wavelength conversion portion 115 may be formed to individually cover each of the plural first LED chips 111.

The second LED package 120 is disposed on the substrate 140. The second LED package 120 includes a second LED chip 121 and a second wavelength conversion portion 125.

The second LED package 120 includes at least one second LED chip 121. If the second LED package 120 includes plural second LED chips 121, the plural second LED chips 121 are electrically connected to one another to form an array.

The second wavelength conversion portion 125 is formed on the substrate 140 to cover the second LED chip 121. The first wavelength conversion portion 125 may be formed to collectively cover the plural second LED chips 121. Alternatively, the second wavelength conversion portion 125 may be formed to individually cover each of the plural second LED chips 121.

The first LED package 110 and the second LED package 120 emit light of the same color. In addition, light from the first LED package 110 has a different color temperature than light from the second LED package 120. For example, the first LED package 110 and the second LED package 120 may emit white light having different color temperatures.

Light emitted from the first LED chip 111 and the second LED chip 121 is warm light. For example, light emitted from the first LED chip 111 and the second LED chip 121 has a color temperature of 1,000 K to 4,000 K. Preferably, light emitted from the first LED chip 111 and the second LED chip 121 has a color temperature of 1,600 K to 3,000 K.

In addition, the first wavelength conversion portion 115 and the second wavelength conversion portion 125 include different phosphors. Thus, light emitted from the first LED package 110 through the first wavelength conversion portion 115 has a different color temperature than light emitted from the second LED package 120 through the second wavelength conversion portion 125.

In one embodiment, the first wavelength conversion portion 115 includes a phosphor having a higher color temperature. For example, the first wavelength conversion portion 115 may include a phosphor having a color temperature of about 3,000 K. In addition, the second wavelength conversion portion 125 includes a phosphor having a lower color temperature. For example, the second wavelength conversion portion 125 may include a phosphor having a color temperature of about 1,800 K.

Accordingly, light from the first LED package 110 has a higher color temperature than light from the second LED package 120. However, it will be understood that the present invention is not limited thereto and the LED package set may be configured such that light from the second LED package 120 has a higher color temperature than light from the first LED package 110, provided that there is a difference in color temperature between the light from the first LED package 110 and the light from the second LED package 120.

A difference in color temperature between the light from the first LED package 110 and the light from the second LED package 120 may range from 500 K to 1,000 K.

An LED package having a lower color temperature may have a lower light intensity than an LED package having a higher color temperature. Thus, in order to supplement light intensity of the second LED package 120, the second LED chip 121 may have a wider light emitting area than the first LED chip 111. That is, the second LED chip 121 may be larger than the first LED chip 111.

The resistor 130 may be disposed on the substrate 140 or embedded in the substrate 140. The resistor 130 has a fixed resistance. The resistor 130 is adapted to distribute current to the first LED package 110 and the second LED package 120.

Although a wiring circuit is not shown in FIG. 1, the first LED package 110 is connected in series to the resistor 130. Further, the second LED package 120 is connected in parallel to the first LED package 110 and the resistor 130 connected in series.

The LED package set 100 according to the present invention emits mixed light composed of light having different color temperatures.

Voltage changed in magnitude according to an external dimming signal is applied to the LED package set 100. A resistance ratio of the first LED package 110 to the second LED package 120 is changed depending on change in voltage and the resistor 130.

Current is distributed to the first LED package 110 and the second LED package 120 in inverse proportion to the resistance ratio.

Here, the dimming signal is a signal that controls magnitude of electricity applied to the substrate 140 to regulate color temperature of light emitted from the LED package set 100.

As current flowing through the first LED package 110 and the second LED package 120 is changed, the strength or brightness of light emitted from each of the first LED package 110 and the second LED package 120 is changed. Accordingly, a color temperature of mixed light from the LED package set 100 is regulated by change in strength or brightness ratio between light from the first LED package 110 and light from the second LED package 120 having different color temperatures.

In this embodiment, the first LED package 110 and the second LED package 120 are described as including the first wavelength conversion portion 115 and the second wavelength conversion portion 125, respectively. However, it should be understood that the present invention is not limited thereto and the first wavelength conversion portion 115 and the second wavelength conversion portion 125 may be omitted, provided that each of the first LED chip 111 and the second LED chip 121 emits light having a color and color temperature desired by a user.

In this embodiment, the LED package set 100 is described as including two LED packages emitting light having different color temperatures. However, it should be understood that the present invention is not limited thereto and the LED package set 100 may include three or more LED packages emitting light having different color temperatures. In this case, the color temperature of light emitted from the LED package set 100 can be more accurately regulated by adjusting resistance of resistors connected in series to the LED packages.

In another embodiment, the first LED chip 111 of the first LED package 110 and the second LED chip 121 of the second LED package 120 may emit light having different color temperatures. Here, the first LED package 110 and the second LED package 120 may be covered by a single common wavelength conversion portion.

In a further embodiment, the first LED chip 111 of the first LED package 110 and the second LED chip 121 of the second LED package 120 may emit light having the same color temperature. That is, the first LED chip 111 may be the same as the second LED chip 121. Here, the first wavelength conversion portion 115 of the first LED package 110 and the second wavelength conversion portion 125 of the second LED package 120 may include phosphors having different color temperatures, respectively.

FIG. 3 is a circuit diagram of an LED package set according to one embodiment of the present invention.

An LED package set 100 represented by the circuit of FIG. 3 is the LED package set 100 of FIG. 1 and FIG. 2.

Referring to FIG. 3, a first LED array 113 of the first LED package (110 of FIG. 1) is connected in series to the resistor 130. Here, one end of the resistor 130 is connected to a cathode of the first LED array 113, that is, the other end of the first LED array. In addition, a second LED array 123 of the second LED package (120 of FIG. 2) is connected in parallel to the first LED array 113 and the resistor 130 connected in series. Here, an anode of the first LED array 113 and an anode of the second LED array 123 are connected to a first terminal 151. In addition, the other end of the resistor 130 and a cathode of the second LED array 123 are connected to a second terminal 152. The first terminal 151 and the second terminal 152 are connected to opposite ends of a constant current system 160, respectively. The resistor 130 has a predetermined fixed resistance. Here, the constant current system 160 is a system that supplies electricity to the LED package set 100 in a constant current mode.

Electricity applied to the LED package set 100 is changed according to an external dimming signal. That is, voltage and current applied to the LED package set 100 are changed according to the external dimming signal. As voltage applied to the LED package set 110 is changed according to the dimming signal, a ratio of resistance offered by the first LED package 110 and the resistor 130 to resistance offered by the second LED package 120 is changed. Current from the constant current system 160 is distributed to the first LED package 110 and the second LED package 120 in inverse proportion to the ratio.

Next, the present invention will be described using an example in which the dimming signal indicates a dimming level of 100% when the light intensities of the first LED package (110 of FIG. 1) and the second LED package (120 of FIG. 2) reach the same maximum values, and current applied to the LED package set has a maximum value of 30 mA.

In this example, the first LED package (110 of FIG. 1) has a color temperature of 3,000 K and the second LED package (120 of FIG. 2) has a color temperature of 1,800 K. Further, the resistor 130 has a resistance of 1 kΩ.

At a dimming level of 10%, a current of 3 mA is applied to the first terminal 151. Here, all of the current flows through the second LED package (120 of FIG. 2). Thus, the first LED package (110 of FIG. 1) is in an OFF state. The second LED package (120, FIG. 2) emits light having an intensity corresponding to 3 mA. Since only the second LED package (120 of FIG. 2) emits light, light from the LED package set 100 has a color temperature of 1,800 K.

At a dimming level of 20%, a current of 6 mA is applied to the first terminal 151. Here, a current of 1.2 mA flows through the first LED package (110 of FIG. 1) and a current of 4.8 mA flows through the second LED package (120 of FIG. 2). As a result, the LED package set 100 emits light having a color temperature of 2,100 K.

At a dimming level of 50%, a current of 15 mA is applied to the first terminal 151. Here, a current of 4.5 mA flows through the first LED package (110 of FIG. 1) and a current of 10.5 mA flows through the second LED package (120 of FIG. 2). As a result, the LED package set 100 emits light having a color temperature of 2,400 K.

At a dimming level of 75%, a current of 22.5 mA is applied to the first terminal 151. Here, a current of 9 mA flows through the first LED package (110 of FIG. 1) and a current of 13.5 mA flows through the second LED package (120 of FIG. 2). As a result, the LED package set 100 emits light having a color temperature of 2,550 K.

At a dimming level of 100%, a current of 30 mA is applied to the first terminal 151. Here, a current of 15 mA flows through each of the first LED package (110 of FIG. 1) and the second LED package (120 of FIG. 2). As a result, the LED package set 100 emits light having a color temperature of 2,700 K.

Thus, the LED package set 100 according to the present invention can emit light having various color temperatures by distributing current to the first LED package (110 of FIG. 1) and the second LED package (120 of FIG. 2) according to the dimming signal.

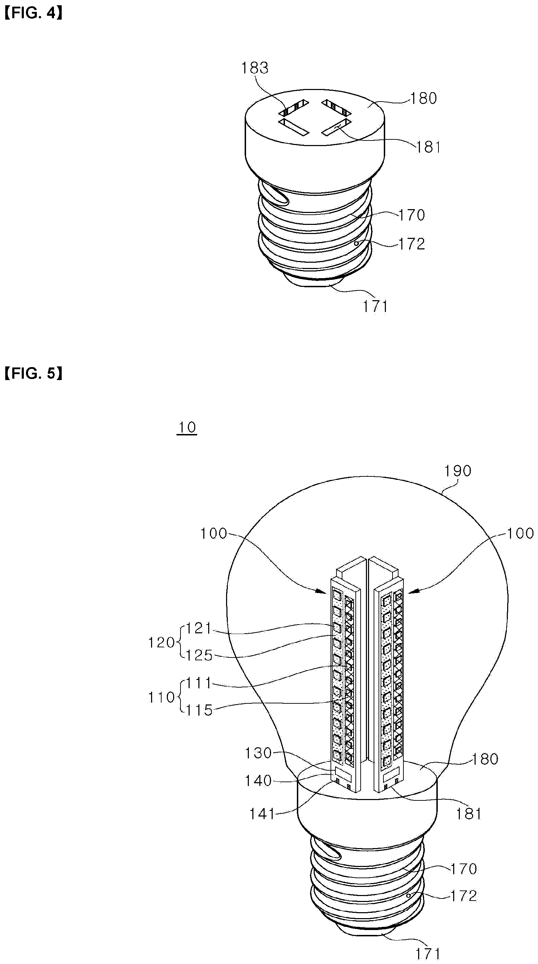

FIG. 4 and FIG. 5 are exemplary views of an LED bulb according to a first embodiment of the present invention.

FIG. 4 is an exemplary view of a base 170 and a holder 180 of an LED bulb 10 and FIG. 5 is an exemplary view of the LED bulb 10 with an LED package set 100 mounted thereon.

The LED bulb 10 includes the base 170, the LED package set 100, the holder 180, and a light transmissive cover 190. Here, the LED package set 100 is the LED package set 100 of FIG. 1 to FIG. 3. See FIG. 1 to FIG. 3 for details of the LED package set 100.

The base 170 is coupled to a socket for connection to an external power supply. The base 170 is formed on an outer surface thereof with a first external electrode 171 and a second external electrode 172 electrically connected to the socket. The first external electrode 171 and the second external electrode 172 receive electricity from the external power supply.

The light transmissive cover 190 is coupled to the base 170 to enclose internal components such as the holder 180 and the LED package set 100. The light transmissive cover 190 is formed of a light transmissive material. For example, the light transmissive cover 190 is formed of glass.

The holder 180 and the LED package set 100 are disposed in the LED bulb 10. Here, an interior of the LED bulb 10 is an inner space formed by coupling the base 170 to the light transmissive cover 190.

The holder 180 is disposed under the LED package set 100 to support the LED package set 100 in an upright position. Referring to FIG. 4, the holder 180 includes a connection portion 181 provided in the form of a groove or a through-hole. The connection portion 181 is formed therein with a pair of connection terminals 183 formed of a conductive material. One of the pair of connection terminals 183 is electrically connected to the first external electrode 171 of the base 170 and the other connection terminal is electrically connected to the second external electrode 172 of the base 170. The pair of connection terminals 183 is connected to the first external electrode 171 and the second external electrode 172 of the base 170 via conductive parts (not shown), such as wires, respectively. In this embodiment, the holder 180 has been described as a separate component from the base 170. However, it should be understood that the present invention is not limited thereto and the holder 180 may be integrally formed with the base 170.

The LED bulb 10 includes at least one LED package set 100. In FIG. 5, the LED bulb 10 is shown as including four LED package sets 100. However, it should be understood that the present invention is not limited thereto and the number of LED package sets 100 mounted on the LED bulb 10 may vary depending on choices made by those skilled in the art.

The LED package set 100 is secured to the holder 180. One end of the LED package set 100 is inserted into the connection portion 181 of the holder 180. Thus, the LED package set 100 is disposed in an upright position inside the LED bulb 10. That is, the LED package set 100 is stood such that the first LED package 110 and the second LED package 120 face an inner surface of the light transmissive cover 190.

In addition, the one end of the LED package set 100 inserted into the connection portion 181 corresponds to one end of the substrate 140 at which the pair of electrode pads 141 is formed. When the one end of the LED package set 100 is inserted into the connection portion 181, the pair of connection terminals 183 of the connection portion 181 is brought into contact with and electrically connected to the pair of electrode pads 141 of the substrate 140. Accordingly, electricity changed according to the dimming signal is applied to the LED package set 100 through the first external electrode 171 and the second external electrode 172 of the base 170 and the pair of connection terminals 183 of the holder 180.

Since the LED bulb 10 is configured such that the LED package set 100 is secured by being inserted into the holder 180, it is easy to replace the LED package set 100 upon failure of the LED package set.

According to the present invention, the LED package set 100 allows light intensities of the first LED package 110 and the second LED package 120 to be regulated depending on current applied thereto. That is, color temperature of light emitted from the LED bulb 10 is changed with change in current applied from the outside. Thus, the LED bulb 10 can emit light having a color temperature suitable for a specific application or environment.

In addition, according to the embodiment of the invention, the LED package set 100 includes the resistor 130 connected in series to the first LED package 110 and connected in parallel to the second LED package 120. In addition, current is distributed to the first LED package 110 and the second LED package 120 depending on resistance offered by the first LED package 110 and the resistor 130 and resistance offered by the second LED package 120. Thus, the LED bulb 10 can emit light changed in color temperature according to the dimming signal.

In addition, according to the present invention, the LED bulb 10 can evenly emit light laterally by including the plurality of LED package sets 100.

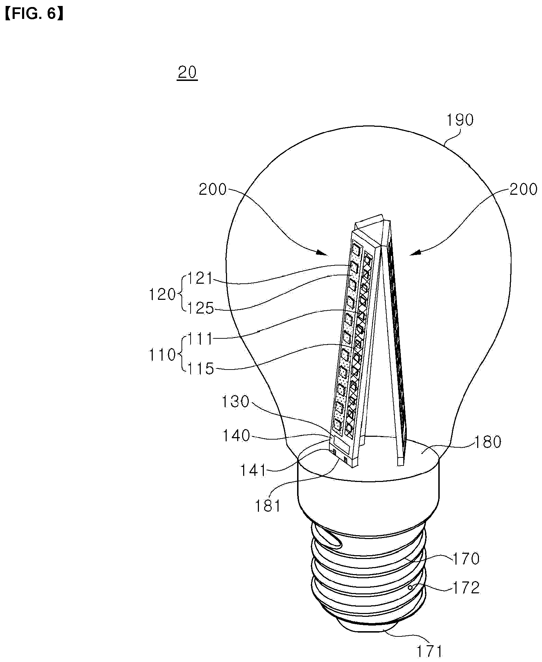

FIG. 6 is an exemplary view of an LED bulb according to a second embodiment of the present invention.

Description of components of the LED bulb 20 according to the second embodiment which are the same as those of the LED bulb 20 according to the first embodiment will be omitted. See FIG. 1 to FIG. 5 for details of the components not described in this embodiment.

The LED bulb 20 according to the second embodiment includes at least one LED package set 200. The LED package set 200 is formed with a bent portion 210. The bent portion 210 is formed on the substrate 140 between the pair of electrode pads 141 and the first LED chip 111, the second LED chip 121, and the resistor 130. In addition, the bent portion 210 is formed in a transverse direction of the substrate 140. Here, the transverse direction of the substrate 140 is a perpendicular direction with respect to a straight line connecting one end of the substrate 140 at which the pair of electrode pads 141 is formed to the other end of the substrate 140.

The bent portion 210 is provided to bend the LED package set 200 at a predetermined angle. The bent portion 210 may be formed in any shape and by any method so long as the LED package set 200 can be bent with respect to the bent portion. For example, the bent portion 210 may be formed by half-etching a portion of the substrate 140. Alternatively, the bent portion 210 may be provided in the form of at least one through-hole formed through a portion of the substrate 140. Alternatively, the bent portion 210 may be provided in the form of an indentation formed by pressing a pointed object into a portion of the substrate 140.

The LED package set 200 may be bent about the bent portion 210 such that the first LED package 110 and the second LED package 120 face in an upward direction of the LED bulb 20, as shown in FIG. 6.

The LED bulb 20 including the LED package sets 200 configured as above can evenly emit light upwards as well as laterally.

Alternatively, the LED bulb 20 may include an LED package set 200 bent downwards as opposed to FIG. 6 to evenly emit light laterally and downwards. Alternatively, the LED bulb 20 may include both an LED package set bent upwards and an LED package set bent downwards to evenly emit light laterally, upwards, and downwards.

Although some embodiments have been described herein, it should be understood that these embodiments are provided for illustration only and are not to be construed in any way as limiting the present invention, and that various modifications, changes, alterations, and equivalent embodiments can be made by those skilled in the art without departing from the spirit and scope of the invention.

The invention provides, in particular, the following:
1. An LED package set comprising:
   - a substrate;
   - a first LED package disposed on the substrate and comprising at least one first LED chip;
   - a second LED package disposed on the substrate and comprising at least one second LED chip; and
   - a resistor disposed on the substrate, the resistor being connected in series to the first LED package and connected in parallel to the second LED package;
   wherein the second LED package is connected in parallel to the first LED package and the resistor, and the first LED package and the second LED package emit light having different color temperatures.
2. The LED package set according to item 1, wherein:
   - the substrate comprises a pair of electrode pads;
   - one end of the first LED package and one end of the second LED package are connected to one of the pair of electrode pads;
   - one end of the resistor is connected to the other end of the first LED package; and
   - the other end of the second LED package and the other end of the resistor are connected to the other of the pair of electrode pads.
3. The LED package set according to item 1, wherein current is distributed to the first LED package and the second LED package depending on resistance offered by the first LED package and the resistor connected in series and resistance offered by the second LED package, wherein preferably a color temperature of mixed light composed of light from the first LED package and light from the second LED package is changed depending on current flowing through the first LED package and current flowing through the second LED package.
4. The LED package set according to item 1, wherein:
   - the first LED package comprises a first wavelength conversion portion covering the at least one first LED chip; and
   - the second LED package comprises a second wavelength conversion portion covering the at least one second LED chip.
5. The LED package set according to item 4, wherein the first LED chip and the second LED chip emit light having the same color temperature.
6. The LED package set according to item 5, wherein the first wavelength conversion portion and the second wavelength conversion portion comprise phosphors having different color temperatures, respectively.
7. The LED package set according to item 1, further comprising:
   - a wavelength conversion portion covering both the first LED chip and the second LED chip.
8. An LED bulb comprising:
   - a base formed with an external electrode pad receiving electricity from an external power supply;
   - an LED package set comprising a substrate having a pair of electrode pads formed at one end thereof, a first LED package comprising at least one first LED chip, a second LED package comprising at least one second LED chip, and a resistor;
   - a holder formed with a connection portion receiving one end of the LED package set and electrically connected to the pair of electrode pads of the substrate; and
   - a light transmissive cover enclosing the LED package set and coupled at one end thereof to the base;

   wherein the first LED package, the second LED package, and the resistor are disposed on the substrate,
   the first LED package and the second LED package are connected in parallel and emit light having different color temperatures, and
   the resistor is connected in series to the first LED package and connected in parallel to the second LED package.
9. The LED bulb according to item 8, wherein:
   - one end of the first LED package and one end of the second LED package are connected to one electrode pad of the pair of electrode pads;
   - one end of the resistor is connected to the other end of the first LED package; and
   - the other end of the second LED package and the other end of the resistor are connected to the other of the pair of electrode pads.
10. The LED bulb according to item 8, wherein current is distributed to the first LED package and the second LED package depending on resistance offered by the first LED package and the resistor connected in series and resistance offered by the second LED package.
11. The LED bulb according to item 10, wherein a color temperature of mixed light composed of the light from the first LED package and the light from the second LED package is changed depending on current flowing through the first LED package and current flowing through the second LED package.
12. The LED bulb according to item 8, wherein the connection portion of the holder is provided in the form of a groove or hole into which one end of the substrate is inserted, and comprises a pair of connection terminals electrically connected to the pair of electrode pads of the substrate.
13. The LED bulb according to item 8, wherein the substrate further comprises a bent portion formed between the pair of electrode pads and the first LED chip, the second LED chip, and the resistor to allow the substrate to be bent upwards or downwards with respect thereto.
14. The LED bulb according to item 8, wherein:
   - the first LED package comprises a first wavelength conversion portion covering the first LED chip; and
   - the second LED package comprises a second wavelength conversion portion covering the second LED chip.
15. The LED bulb according to item 8, further comprising:
   - a wavelength conversion portion covering both the first LED chip and the second LED chip.

## Claims

1. An LED package set comprising:
a substrate;
a first LED package disposed on the substrate and comprising a first LED array including at least one first LED chip;
a second LED package disposed on the substrate and comprising a second LED array including at least one second LED chip; and
a resistor disposed on the substrate, the resistor being connected in series to the first LED package and connected in parallel to the second LED package, and having a fixed resistance;
wherein the second LED package is connected in parallel to the first LED package and the resistor, and the first LED package and the second LED package emit light having different color temperatures,
wherein a ratio of a resistance offered by the first LED package and the resistor to a resistance offered by the second LED package is changed as a power change according to the dimming signal,
wherein current is distributed to the first LED package and the second LED package in inverse proportion to the ratio,
wherein a strength of light emitted from each of the first LED array and the second LED array is changed, as the values of current flowing through the first LED array and the second LED array are changed.

2. The LED package set according to claim 1, wherein:
the substrate comprises a pair of electrode pads;
one end of the first LED package and one end of the second LED package are connected to one of the pair of electrode pads;
one end of the resistor is connected to the other end of the first LED package; and
the other end of the second LED package and the other end of the resistor are connected to the other of the pair of electrode pads.

3. The LED package set according to claim 1, wherein light from the first LED package has a higher color temperature than light from the second LED package.

4. The LED package set according to claim 3, wherein a difference in color temperature between light from the first LED package and light from the second LED package is at least 500 K.

5. The LED package set according to claim 1, wherein a color temperature of a mixture of light from the first LED package and the second LED package changes depending on the value of current flowing through the first LED package and the value of current flowing through the second LED package.

6. The LED package set according to claim 1, wherein the first LED package includes a first wavelength conversion portion covering the first LED chip, and the second LED package includes a second wavelength conversion portion covering the second LED chip.

7. The LED package set according to claim 6, wherein the first LED chip and the second LED chip are configured to emit light having the same color temperature.

8. The LED package set according to claim 7, wherein the first wavelength conversion portion and the second wavelength conversion portion include phosphors having different color temperatures, respectively.

9. The LED package set according to claim 1, further includes a wavelength conversion portion covering each the first LED chip and the second LED chip.

10. The LED package set according to claim 1, wherein the first LED chip and the second LED chip are configured to emit light having different color temperatures.
